**Europäisches Patentamt**

**European Patent Office**

**Office européen des brevets**

(19)

(11) Veröffentlichungsnummer: **0 257 328 B1**

(12) **EUROPÄISCHE PATENTSCHRIFT**

(45) Veröffentlichungstag der Patentschrift: **23.10.91**

(51) Int. Cl.5: **H01L 21/00, H01L 29/08**

(21) Anmeldenummer: **87110950.0**

(22) Anmeldetag: **28.07.87**

(54) **Verfahren zur Stabilisierung von pn-Übergängen.**

(30) Priorität: **11.08.86 DE 3627209**

(43) Veröffentlichungstag der Anmeldung:
**02.03.88 Patentblatt 88/09**

(45) Bekanntmachung des Hinweises auf die
Patenterteilung:
**23.10.91 Patentblatt 91/43**

(84) Benannte Vertragsstaaten:
**DE FR GB IT NL**

(56) Entgegenhaltungen:
**GB-A- 2 168 194**
**US-A- 3 764 423**
**US-A- 3 771 218**
**US-A- 4 244 752**

**IBM TECHNICAL DISCLOSURE BULLETIN,
Band 24, Nr. 9, Februar 1982, Seiten
4728-4729, New York, US; H.M. DALAL et al.:
"Methods of opening contact holes in oxide-
nitride structure"**

(73) Patentinhaber: **SIEMENS AKTIENGESELL-
SCHAFT
Wittelsbacherplatz 2
W-8000 München 2(DE)**

(72) Erfinder: **Reichert, Hansjörg, Dr. Dipl.-Phys.
Weissenseestrasse 83
W-8000 München 90(DE)**
Erfinder: **Scharf, Ludwig, Dipl.-Phys.
Montgelasstrasse 33
W-8000 München 80(DE)**
Erfinder: **Deckers, Margarete, Dipl.-Phys.
Bodenschwingstrasse 6
W-8000 München 90(DE)**

## Beschreibung

Die Erfindung betrifft ein Verfahren zur Stabilisierung von pn-Übergängen nach dem Oberbegriff des Anspruchs 1.

Zur guten Passivierung eines Mikrowellentransistors ist das Aufbringen einer Silicium-Nitrid-Schicht im aktiven Bereich zweckmäßig. Da die Silicium-Nitrid-Schicht aus verschiedenen Gründen nicht direkt auf Silicium aufgebracht werden soll, wird diese Silicium-Nitrid-Schicht heute üblicherweise über einer Silicium-Dioxid-Schicht abgeschieden bzw. wird die Silicium-Dioxid-Schicht in einer nitrierenden Atmosphäre teilweise in eine Silicium-Nitrid-Schicht umgewandelt. In all diesen Fällen entsteht eine Passivierungs-Doppelschicht bestehend aus Silicium-Dioxid direkt auf dem Substrat und Silicium-Nitrid, welches sich auf dem Silicium-Dioxid befindet. Diese Passivierungs-Doppelschicht muß als Ganzes strukturiert werden.

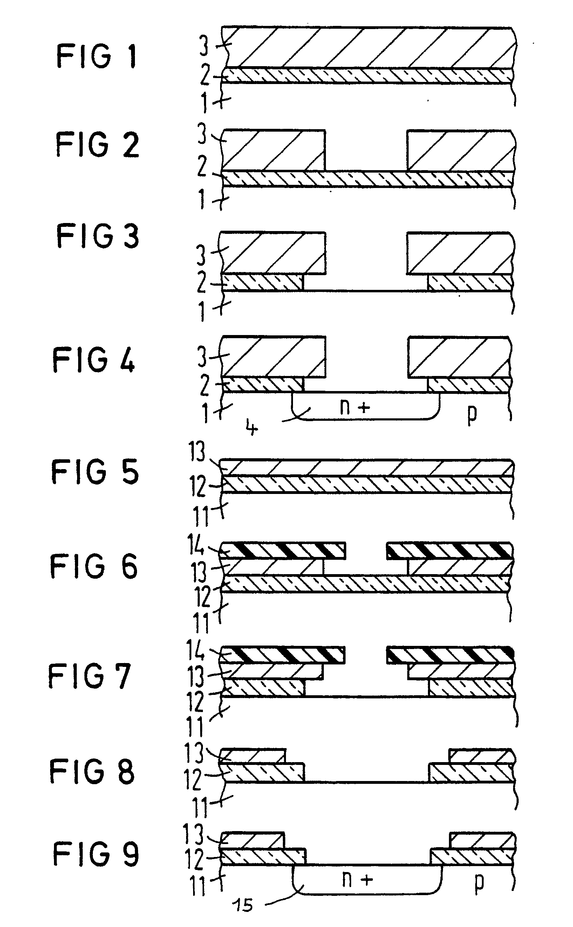

Ein Verfahren zur Strukturierung einer Passivierungsdoppelschicht, bestehend aus Silicium-Nitrid über Silicium-Dioxid, nach dem Stand der Technik wird anhand der Figuren 1 bis 4 beschrieben.

Fig. 1 zeigt ein Halbleitersubstrat 1, auf dem eine Oxidschicht 2 angeordnet ist, über der sich eine Silicium-Nitridschicht 3 befindet.

Sollen mit einem Verfahren nach den Fig. 1 bis 4 beispielsweise Emitterstreifen bei npn-Silicium-Hochfrequenz-Transistoren strukturiert werden, so ist der darunter liegende Bereich die p-Basiszone.

Als Oxidschicht 2 kann thermisch eine dünne Silicium-Dioxidschicht von beispielsweise 30 nm Dicke erzeugt werden. Die Silicium-Dioxid-Schicht kann jedoch auch mit Hilfe eines CVD-Verfahrens abgeschieden werden. Als Silicium-Nitridschicht 3 kann beispielsweise eine 120nm dicke $Si_3N_4$-Schicht erzeugt werden. Die Silicium-Nitrid-Schicht 3 kann durch Nitrieren der Oxidschicht 2 in einer nitrierenden Atmosphäre oder ebenfalls mit Hilfe von CVD-Abscheidung erzeugt werden. Als Silicium-Nitrid-Schicht 3 kann eine bei hoher Temperatur erzeugte Schicht verwendet werden. Als Silicium-Nitrid-Schicht kann auch eine Silicium-Oxinitrid-Schicht Verwendung finden.

Nach Erzeugen der Passivierungsdoppelschicht wird bei einem Verfahren nach dem Stand der Technik die Silicium-Nitrid-Schicht 3 mit Hilfe eines fotolithografischen Verfahrens strukturiert. Sodann wird die für das fotolithografische Verfahren verwendete Lackmaske abgelöst. Das dadurch entstandene Gebilde ist in Fig. 2 dargestellt. Nach Strukturierung der Silicium-Nitrid-Schicht 3 wird mit Hilfe einer naßchemischen Ätzung die Oxidschicht 2 strukturiert. Das Ergebnis dieses Vorganges ist in Fig. 3 zu sehen.

Nach Strukturierung der Passivierungsdoppelschicht erfolgt eine Implantation und eine anschließende Diffussion zur Erzeugung des Emitters 4, der $n^+$-dotiert ist. Das Resultat dieser Verfahrensschritte ist in Figur 4 dargestellt.

Bei der naßchemischen Ätzung des Oxid 2 ist eine Unterätzung des Oxid 2 nicht zu vermeiden. Diese Unterätzung des Oxid 2 führt zur Bildung von Hohlräumen in der Passivierungs-Doppelschicht, die durch die nachfolgenden Prozesse beim Stand der Technik nicht mehr geschlossen werden.

Bei der Emitter-Implantation bewirkt das überhängende Nitrid 3 eine Abschattung der Randbereiche des freiliegenden Siliziums, die folglich nicht mit Implantationsteilchen versehen werden. Bei der folgenden Emitterdiffusion ist es daher nicht immer gewährleistet, daß der Emitterbereich 4 seitlich bis unter das Oxid 2 diffundiert. Auch bei vollständiger Überdeckung des pn-Überganges zwischen Emitter 4 und dem anschließenden p-dotierten Bereich des Siliziums 1 durch das Oxid 2 führen die oben erwähnten Hohlräume Zu Störungen. Diese Hohlräume können mit der Außenatmosphäre des elektronischen Bauelementes verbunden sein und somit als Gasleitungen wirken. Damit können störende Stoffe, insbesondere Wasserstoff, in die Nähe des pn-Überganges gelangen und zur elektrischen Instabilität des elektronischen Bauelementes führen.

Zur Beseitigung des Nitridüberhanges könnte folgendes Verfahren benutzt werden: Nach der naßchemischen Ätzung des Oxids 2 wird das Nitrid 3 nochmals ganzflächig, d. h. ohne mit Lack oder mit einer sonstigen Schicht bedeckt zu sein, überätzt, bis das Nitrid 3 nur noch die halbe der ursprünglichen Schichtdicke besitzt. Da das überhängende Nitrid 3 bei dieser nochmaligen ganzflächigen Überätzung sowohl von oben als von unten angegriffen wird, bricht der Überhang des Nitrids 3 ab, weshalb sich kein Hohlraum mehr bilden kann. Die schützende Nitridschicht bleibt dabei in ausreichender Stärke erhalten (US-A-3 764 423).

Bei einem solchen Verfahren stellt sich jedoch die nochmalige, ganzflächige Nitrid-Überätzung als Problem dar:

Der Ätzangriff auf das Nitrid 3 ist ungleichmäßig, was zu einer schwankenden Nitriddicke führt.

Ein weiterer Nachteil eines solchen Verfahrens besteht darin, daß nach der nochmaligen, ganzflächigen Nitrid-Überätzung die Nitridkante immer mit der Oxidkante zusammenfällt. Dies führt zu sehr steilen Kanten der aus Nitrid und Oxid bestehenden Passivierungs-Doppelschicht. Sehr steile Kanten können bei der anschließenden Metallisierung vermehrt zu Metallabrissen führen und somit die Ausbeute oder die Qualität verringern.

Aus IBM Technical Disclosure Bulletin, Band 24, Nr. 9, Februar 1982, Seiten 4728-4729, ist ein Verfahren zum Öffnen von Kontaktlöchern in einer Oxid-Nitrid-Struktur bekannt. Dabei wird eine verbesserte Metallisierung eines Halbleiter-Bauelements erzielt. Dabei wird ein Nitridüberhang vermieden durch Vermeiden von naßchemischem Ätzen und durch Verwendung von physikalischen Ätztechniken, beispielsweise von reaktivem Ionenätzen oder von Ionenätzen.

Der vorliegenden Erfindung liegt die Aufgabe zugrunde, ein Verfahren der eingangs genannten Art anzugeben, welches eine hohe elektrische Stabilität des elektronischen Bauelementes ermöglicht.

Diese Aufgabe wird erfindungsgemäß durch ein Verfahren nach dem Anspruch 1 gelöst.

Vorteile und Ausgestaltungen der Erfindung sind in den Unteransprüchen, der Beschreibung und der Zeichnung dargelegt.

Bei einem Verfahren nach der Erfindung werden Hohlräume und freiliegende pn-Übergänge vermieden.

Ein Verfahren nach der Erfindung eignet sich insbesondere zur Stabilisierung von flachen pn-Übergängen.

Durch das zusätzliche Nachätzen des überhängenden Nitrids und durch das erst daran anschließende Entfernen des die Nitridschicht bedeckenden Lackes oder einer anderen das Nitrid bedeckende Schicht wird überhängendes Nitrid entfernt und wird so der Entstehung eines Hohlraumes entgegengewirkt. Durch geeignete Wahl der Ätzzeit beim zusätzlichen Nachätzen des überhängenden Nitrids läßt sich ein beliebiges Stufenprofil der Oxid-Nitrid-Passivierungs-Doppelschicht erzeugen.

Außerdem findet keine Abschattung bei der Emitter-Implantation statt, wodurch ermöglicht wird, daß der Basis-Emitter-pn-Übergang sich nach der Diffusion soweit wie möglich unter dem Oxid befindet.

Das Oxid muß mindestens so dick sein, daß es noch gegen die Emitter-Implantation maskiert.

Die Erfindung ist nicht auf die Stabilisierung von Basis-Emitter-Übergängen beschränkt. Die Erfindung ist zur Erzeugung von pn-Übergängen geeignet.

Ein Verfahren nach der Erfindung hat folgende Vorteile:

1. Mit Hilfe eines Verfahrens nach der Erfindung können Hohlräume vermieden werden, die im aktiven Bereich eines Transistors oder eines anderen elektronischen Bauelementes als Gasleitungen wirken und zur Instabilität des betreffenden Bauelements führen können.

2. Ein Verfahren nach der Erfindung ermöglicht es, daß pn-Übergänge soweit wie möglich unter dem Oxid liegen, da keine Abschattung bei der Erzeugung des pn-Übergangs, beispielsweise bei der Emitter-Implantation, mehr auftritt.

3. Ein Verfahren nach der Erfindung ermöglicht die Erhaltung der Nitridschicht als Diffusionsbarriere über dem Oxid im aktiven Transistorbereich.

Das elektronische Bauelement ist somit bereits nach der Metallisierung hermetisch dicht abgeschlossen, was bei einem Verfahren nach dem Stand der Technik noch nicht der Fall ist.

4. Bei einem Verfahren nach der Erfindung kann bei der Nachätzung des Nitridüberhanges über die Ätzzeit die seitliche Unterätzung des Nitrids unter dem Lack oder unter einer anderen das Nitrid bedeckenden Schicht kontrolliert werden, so daß ein flaches Stufenprofil der Oxid-und Nitrid-Passivierungs-Doppelschicht erzeugt werden kann. Dadurch kann die Gefahr von Metallabrissen der später darüber aufzubringenden Metallisierung deutlich verringert werden.

5. Ein Verfahren nach der Erfindung läßt sich leicht in übliche Fertigungsprozesse integrieren.

Beim Nachätzen des überhängenden Nitrids verhindert der das Nitrid noch bedeckende Fotolack bzw. eine andere das Nitrid bedeckende Schicht das ganzflächige Überätzen des Nitrids und damit eine Reduzierung der Nitriddicke und auch eine schwankende Nitriddicke.

Ein Ausführungsbeispiel der Erfindung ist schematisch in der Zeichnung dargestellt.

Fig. 1 bis 4 erläutern ein Verfahren nach dem Stand der Technik.

Fig. 5 bis 9 erläutern ein Verfahren nach der Erfindung.

In Fig. 5 ist dargestellt, daß auf einem p-dotierten Silicium-Halbleiter-Bereich 11 eine Silicium-Dioxid-Schicht 12 mit einer Dicke von mehr als 100 nm abgeschieden oder sonstwie erzeugt wird und daß auf dieser Oxidschicht 12 eine Silicium-Nitrid $(Si_3N_4)$-Schicht 13 von beispielsweise 120 nm Dicke erzeugt wird.

Fig. 6 zeigt, daß die Nitridschicht 13 mit Hilfe eines Fotolacks 14 mit einem fotolothografischen Verfahren strukturiert wird. Die Lackmaske 14 bleibt erhalten.

Fig. 7 zeigt ein Gebilde nach Fig. 6 nach der naßchemischen Ätzung des Oxids 12 mit Hilfe der kombinierten Nitrid-und Lackmaske.

Fig. 8 zeigt das Gebilde von Fig. 7 nach dem Nachätzen des überhängenden Nitrids und nach dem anschließenden Entfernen des Fotolackes 14.

Fig. 9 zeigt das Gebilde von Fig. 8 nach der Erzeugung eines Emitters 15, welcher $n^+$-dotiert ist, nach der Emitter-Implantation und nach der anschließenden Emitter-Diffusion.

## Patentansprüche

1. Verfahren zur Stabilisierung eines pn-Überganges, bei dem

    a) auf einem Halbleitersubstrat (11) über einem Bereich einer ersten Dotierungsart

b) eine Oxidschicht (12) erzeugt wird,

c) auf der Oxidschicht (12) eine Nitridschicht (13) erzeugt wird,

d) die Nitridschicht (13) fotolithografisch mit Hilfe eines Fotolackes (14) strukturiert wird,

e) die Oxidschicht (12) naßchemisch mit Hilfe der kombinierten Nitrid- und Lackmaske geätzt wird,

f) innerhalb des naßchemisch geätzten Bereiches eine Implantation mit Teilchen einer der ersten Dotierungsart entgegengesetzten zweiten Dotierungsart und anschließend eine Diffusion erfolgt,

**dadurch gekennzeichnet, daß**

g) nach der naßchemischen Ätzung des Oxids (12) überhängendes Nitrid (13) nachgeätzt wird, und daß

h) danach der Fotolack (14) entfernt wird.

2. Verfahren nach Anspruch 1,
**dadurch gekennzeichnet, daß** als Halbleitersubstrat Silicium verwendet wird.

3. Verfahren nach Anspruch 1 oder 2,
**dadurch gekennzeichnet, daß** als Oxid (12) Silicium-Oxid verwendet wird.

4. Verfahren nach einem der Ansprüche 1 bis 3,
**dadurch gekennzeichnet, daß** als Nitrid (13) Silicium-Nitrid verwendet wird.

5. Verfahren nach einem der Ansprüche 1 bis 4,
**dadurch gekennzeichnet, daß** ein Stufenprofil der Oxid-Nitrid-Passivierungs-Doppelschicht erzeugt wird.

6. Verfahren nach einem der Ansprüche 1 bis 5,
**dadurch gekennzeichnet, daß** die Oxidschicht (12) eine Dicke von mehr als 100nm erhält.

7. Verfahren nach einem der Ansprüche 1 bis 6,
**dadurch gekennzeichnet, daß** die Nitridschicht (13) eine Dicke von mehr als 100nm erhält.

8. Verfahren nach einem der Ansprüche 1 bis 7 wobei der pn-Übergang flach ausgebildet wird.

9. Verfahren nach einem der Ansprüche 1 bis 8 wobei der pn-Übergang ein Emitter-Basis-Übergang bei einem Transistor ist.

10. Verfahren nach Anspruch 9 wobei der Transistor ein Emitterstreifen aufweisender Hochfrequenz-Transistor ist.

**Claims**

1. Method for stabilising a p-n junction, in which

a) on a semiconductor substrate (11) over a region of a first doping type,

b) an oxide layer (12) is produced,

c) a nitride layer (13) is produced on the oxide layer (12),

d) the nitride layer (13) is configured photolithographically with the aid of a photoresist (14),

e) the oxide layer (12) is etched by wet chemical methods with the aid of the combined nitride and resist mask,

f) within the wet-chemically etched region, an implantation with particles of a second doping type, opposite to the first doping type, is carried out and subsequently a diffusion is carried out,

characterised in that

g) after the wet-chemical etching of the oxide (12) overhanging nitride (13) is re-etched, and in that

h) the photoresist (14) is subsequently removed.

2. Method according to claim 1, characterised in that silicon is used as the semiconductor substrate.

3. Method according to claim 1 or 2, characterised in that silicon oxide is used as the oxide (12).

4. Method according to one of claims 1 to 3, characterised in that silicon nitride is used as the nitride (13).

5. Method according to one of claims 1 to 4, characterised in that a stepped profile of the oxide-nitride passivation double layer is produced.

6. Method according to one of claims 1 to 5, characterised in that the oxide layer (12) is given a thickness of more than 100 nm.

7. Method according to one of claims 1 to 6, characterised in that the nitride layer (13) is given a thickness of more than 100 nm.

8. Method according to one of claims 1 to 7, the p-n junction being of flat construction.

9. Method according to one of claims 1 to 8 the p-n junction being an emitter-base junction in a transistor.

10. Method according to claim 9 the transistor being a high frequency transistor having emitter strips.

## Revendications

1. Procédé pour stabiliser une jonction pn, selon lequel

   a) on forme sur un substrat semiconducteur (11), au-dessus d'une zone possédant un premier type de dopage,

   b) une couche d'oxyde (12),

   c) on forme sur la couche d'oxyde (12) une couche de nitrure (13),

   d) on structure par voie photolithographique la couche de nitrure (13) à l'aide d'une laque photosensible (14),

   e) on réalise une corrosion par voie chimique humide de la couche d'oxyde (12) à l'aide du masque de nitrure et du masque de laque combinés,

   f) à l'intérieur de la zone corrodée par voie chimique humide, on réalise une implantation avec des particules possédant un second dopage opposé au premier type de dopage, puis on réalise une diffusion,
   caractérisé par le fait que

   g) on applique une corrosion complémentaire au nitrure (13) situé en surplomb, obtenu après la corrosion par voie chimique humide de l'oxyde (12), et

   h) ensuite on élimine la laque photosensible (14).

2. Procédé suivant la revendication 1, caractérisé par le fait qu'on utilise le silicium comme substrat semiconducteur.

3. Procédé suivant la revendication 1 ou 2, caractérisé par le fait qu'on utilise de l'oxyde de silicium en tant qu'oxyde (12).

4. Procédé suivant l'une des revendications 1 à 3, caractérisé par le fait qu'on utilise du nitrure de silicium en tant que nitrure (13).

5. Procédé suivant l'une des revendications 1 à 4, caractérisé par le fait qu'on produit un profil étagé dans la couche double de passivation formée d'oxyde et de nitrure.

6. Procédé suivant l'une des revendications 1 à 5, caractérisé par le fait que la couche d'oxyde (12) possède une épaisseur supérieure à 100 nm.

7. Procédé suivant l'une des revendications 1 à 5, caractérisé par le fait que la couche de nitrure (13) possède une épaisseur supérieure à 100 nm.

8. Procédé suivant l'une des revendications 1 à 7, dans lequel la jonction pn est agencée avec une forme plane.

9. Procédé suivant l'une des revendications 1 à 8, dans lequel la jonction pn est une jonction émetteur-base dans un transistor.

10. Procédé suivant la revendication 9, dans lequel le transistor est un transistor à haute fréquence possédant des bandes d'émetteur.

FIG 1

3
2
1

FIG 2

3
2
1

FIG 3

3
2
1

FIG 4

3
2
1
4
n +
p

FIG 5

13
12
11

FIG 6

14
13
12
11

FIG 7

14
13
12
11

FIG 8

13
12
11

FIG 9

13
12
11
15
n +
p